# FASCICULE DE BREVET EUROPEEN

(11) **EP 4 430 653 B1**
(45) Date de publication et mention de la délivrance du brevet: **08.10.2025**
(21) Numéro de dépôt: 22835457.7
(22) Date de dépôt: 19.10.2022
(51) Int. Cl.: H01L 21/02, H01L 21/762

(54) **PROCEDE DE PREPARATION D'UN SUBSTRAT SUPPORT MUNI D'UNE COUCHE DE PIEGEAGE DE CHARGES**
VERFAHREN ZUR HERSTELLUNG EINES TRÄGERSUBSTRATS MIT EINER LADUNGSEINFANGSCHICHT
METHOD FOR PREPARING A SUPPORT SUBSTRATE PROVIDED WITH A CHARGE-TRAPPING LAYER

(30) Priorité: 09.11.2021 FR 2111876
(43) Date de publication de la demande: 18.09.2024
(73) Titulaire: SOITEC, 38190 Bernin (FR)
(72) Inventeur: KIM, Youngpil, 38190 BERNIN (FR); KONONCHUK, Oleg, 38190 BERNIN (FR); WONG, Chee Hoe, 38190 BERNIN (FR)
(74) Mandataire: IP Trust
(86) Numéro de dépôt international: PCT/FR2022/051974
(87) Numéro de publication internationale: WO 2023/084168

(56) Documents cités:
- EP-A1- 2 503 592
- EP-A1- 3 309 819

## Description

### DOMAINE DE L'INVENTION

La présente invention concerne un procédé de préparation d'un substrat support comprenant une couche de piégeage de charges. Elle concerne également un procédé de report d'une couche mince sur un tel substrat support pour former un substrat composite. Ces substrats support et composite trouvent une application notable dans le domaine des dispositifs intégrés radiofréquences, c'est-à-dire des dispositifs électroniques traitant des signaux dont la fréquence est comprise entre environ 3kHz et 300GHz, par exemple dans le domaine des télécommunications (téléphonie, Wi-Fi, Bluetooth...).

### ARRIERE PLAN TECHNOLOGIQUE DE L'INVENTION

Pour se prémunir ou limiter le phénomène de couplage électromagnétique qui peut se produire entre un dispositif électronique et le substrat support d'un substrat de silicium sur isolant (SOI) sur lequel ce dispositif est formé, il est connu d'insérer entre la couche diélectrique enterrée et le support du SOI, directement sous la couche diélectrique, une couche de piégeage de charges. Cette couche peut être constituée par exemple d'une couche de 0,1 à 10 microns de silicium polycristallin formée sur un substrat de base en silicium monocristallin qui est souvent choisi pour être hautement résistif (c'est-à-dire présentant une résistivité supérieure à 500 ohms.cm, voire même supérieure à 1000 ohms.cm). Les joints des grains formant le polycristal constituent alors des pièges pour les porteurs de charges, ceux-ci pouvant provenir de la couche de piégeage elle-même ou du substrat sous-jacent. De la sorte, on prévient l'apparition d'un plan conducteur sous l'isolant. La fabrication de ce type de substrat SOI bien connu est par exemple décrite dans les documents FR2860341, FR2933233, FR2953640, US2015115480, US7268060, US6544656 ou WO2020008116.

Pour favoriser la création et éviter la recristallisation de la couche de piégeage de charges formée sur le substrat de base en silicium monocristallin, il est connu de former sur ce substrat de base, et avant la formation par dépôt de la couche de piégeage, une couche de diélectrique amorphe, typiquement une couche de dioxyde de silicium. La couche de diélectrique amorphe permet de préserver le caractère polycristallin de la couche de piégeage en évitant sa recristallisation lorsque l'empilement est porté en température.

Le document EP3136421 propose ainsi de former une couche de piégeage en silicium polycristallin sur un substrat de base présentant une résistivité de 700 Ohms-cm. Le substrat de base est oxydé par simple nettoyage ou par oxydation sèche. Puis la couche de piégeage est formée en deux étapes successives de dépôt à l'aide d'un gaz précurseur de trichlorosilane. La première étape vise à former une couche germe à relativement basse température, inférieure à 1010°C, directement sur la couche d'oxyde de silicium, et la seconde étape est conduite à une température supérieure à la première. Selon ce document, cette approche permet de former la couche de piégeage rapidement, et sans déformer excessivement le substrat de base, ce qui pourrait prévenir l'assemblage par adhésion moléculaire de ce substrat lorsqu'il est destiné à former un substrat support d'un substrat de silicium sur isolant.

Le document EP3309819 propose de former, au cours de deux étapes successives conduites dans des équipements distincts, une couche diélectrique sur une face exposé d'un substrat de base et une couche de piégeage de charges sur la couche diélectrique. La couche de piégeage de charge est conduite à une température comprise entre 1050°C et 1200°C.

Le document EP2503592 prévoit quant à lui de réaliser de telles couches « in situ ». Dans ce document, on forme la couche de piégeage sur une couche diélectrique d'un substrat de base en silicium sans sortir le substrat de base de l'équipement utilisé pour former cet empilement. Il peut s'agir d'une chambre d'un bâti d'épitaxie.

Dans cette approche, on dispose le substrat de base dans la chambre de l'équipement, et on fait circuler dans cette chambre un gaz oxydant pour former superficiellement la couche diélectrique au cours d'une étape d'oxydation conduite à une température de l'ordre de 1100°C. Puis, sans extraire le substrat de base de la chambre, on fait circuler un gaz porteur pour évacuer le gaz oxydant et on porte la température de la chambre et/ou du substrat à une température de dépôt relativement réduite, de l'ordre de 900°C ou moins.

Lorsque l'atmosphère oxydante a été évacuée par le gaz porteur et la température de dépôt établie, on introduit le gaz précurseur contenant du silicium pour progressivement former, par dépôt, la couche polycristalline en silicium sur la couche diélectrique. En séquençant ainsi l'introduction des gaz dans la chambre, on évite d'introduire le gaz précurseur avant l'évacuation du gaz oxydant et avant que la température ne soit bien établie à la température cible d'environ 900°C ou moins, et on prévient le dépôt prématuré de silicium polycristallin qui n'aurait pas les qualités requises.

Toutefois, la formation d'une couche de silicium polycristallin à une température de dépôt relativement basse est particulièrement lente, de l'ordre de 0,3 micron par minute à 900°C. Il est en effet bien connu que la vitesse de dépôt est généralement croissante avec la température. Pour améliorer cette vitesse de dépôt, et donc le temps de fabrication du support muni de la couche de piégeage, il peut être envisagé, comme cela a été proposé par le document EP3136421, de seulement former une portion germe de la couche de piégeage à faible température, le reste de la couche pouvant alors être formée à une température relativement plus élevée, et donc plus rapidement.

Même si une telle approche permet effectivement d'améliorer la cadence de production de substrats support, la formation de la couche germe reste une étape particulièrement consommatrice de temps. Il est généralement souhaitable d'accroitre encore la cadence de production, sans compromettre bien entendu la qualité du support.

### OBJET DE L'INVENTION

Un but de l'invention est de proposer un procédé de préparation d'un substrat support muni d'une couche de piégeage de charges adressant au moins en partie ce problème. Plus spécifiquement, un but de l'invention est de proposer un procédé de préparation d'un substrat support muni d'une couche de piégeage de charges dont le temps de mise en œuvre, à qualité comparable, est réduit en comparaison avec les procédés de l'état de la technique. Plus précisément encore, un but de l'invention est de proposer un procédé de préparation d'un substrat support muni d'une couche de piégeage de charges ne nécessitant pas de portion germe formée à relativement basse température d'environ 1010°C ou moins.

### BREVE DESCRIPTION DE L'INVENTION

En vue de la réalisation de ce but, l'objet de l'invention propose un procédé de préparation d'un substrat support muni d'une couche de piégeage de charges. Le procédé comprend l'introduction d'un substrat de base en silicium monocristallin présentant une résistivité supérieure à 500 ohm.cm dans une chambre d'un équipement de dépôt et, sans extraire le substrat de base de la chambre et tout en balayant la chambre à l'aide d'un gaz porteur, les étapes successives suivantes :
- former une couche diélectrique sur une face exposée du substrat de base en introduisant dans la chambre un gaz réactif au cours d'une première période de temps ;
- former une couche de piégeage de charges en silicium polycristallin directement sur la couche diélectrique en introduisant dans la chambre un gaz précurseur contenant du silicium au cours d'une deuxième période de temps postérieure à la première.

Selon l'invention, la durée pendant laquelle la couche diélectrique est exposée uniquement au gaz porteur, entre la première période de temps et la deuxième période de temps, est inférieure à 30 secondes. Selon l'invention également, l'étape de formation de la couche de piégeage de charges est conduite à une température strictement comprise entre 1010°C et 1200°C.

En limitant la durée de l'exposition de la couche diélectrique au gaz porteur seul, entre la première période de temps et la deuxième période de temps, on conditionne ou on maintient l'état de surface de cette couche pour la rendre particulièrement apte à recevoir une couche en silicium polycristallin de qualité, identique à celle obtenue à une température bien moindre dans une approche conforme à l'état de la technique. Ce résultat surprenant permet de faire croitre, à qualité égale, la couche de piégeage avec une vitesse de croissance élevée, et donc de former un substrat support à une cadence améliorée, en comparaison avec une approche conforme à l'état de la technique.

Selon d'autres caractéristiques avantageuses et non limitatives de l'invention, prises seules ou selon toute combinaison techniquement réalisable :
- le gaz porteur comprend, ou est constitué, d'hydrogène ;
- le gaz précurseur contenant du silicium est choisi dans la liste formée du silane, disiliane, trichlorosilane, dicholorosilane et tétrachlorure de silicium ;
- la couche diélectrique est en oxyde de silicium et le gaz réactif comprend entre 0,1% et 10% d'oxygène dans un gaz neutre tel que de l'argon ;
- l'étape de formation de la couche diélectrique est conduite à une température comprise entre 1010°C et 1150°C ;
- la couche diélectrique présente une épaisseur supérieure à 0,5 nm ;
- l'étape de formation de la couche de piégeage de charges est conduite à une température supérieure à 1050°C, ou à 1100°C ;
- la couche de piégeage de charges et la couche diélectrique sont formées à des températures respectives identiques à 50°C près ;
- la durée pendant laquelle la couche diélectrique est exposée uniquement au gaz porteur est inférieure à 20 secondes ou à 15 secondes ;
- la couche de piégeage de charges présente une épaisseur comprise entre 0,1 et 10 microns.

### BREVE DESCRIPTION DES FIGURES

D'autres caractéristiques et avantages de l'invention ressortiront de la description détaillée de l'invention qui va suivre en référence aux figures annexées sur lesquels :
[Fig. 1] La figure 1 représente un substrat support conforme à un premier mode de réalisation ;
[Fig. 2] La figure 2 représente un substrat support conforme à un second mode de réalisation ;
[Fig. 3] La figure 3 représente un substrat composite qui comprend un substrat support conforme à la présente invention ;
[Fig. 4] La figure 4 illustre la succession des deux étapes principales d'un procédé conforme à l'invention.

### DESCRIPTION DETAILLEE DE L'INVENTION

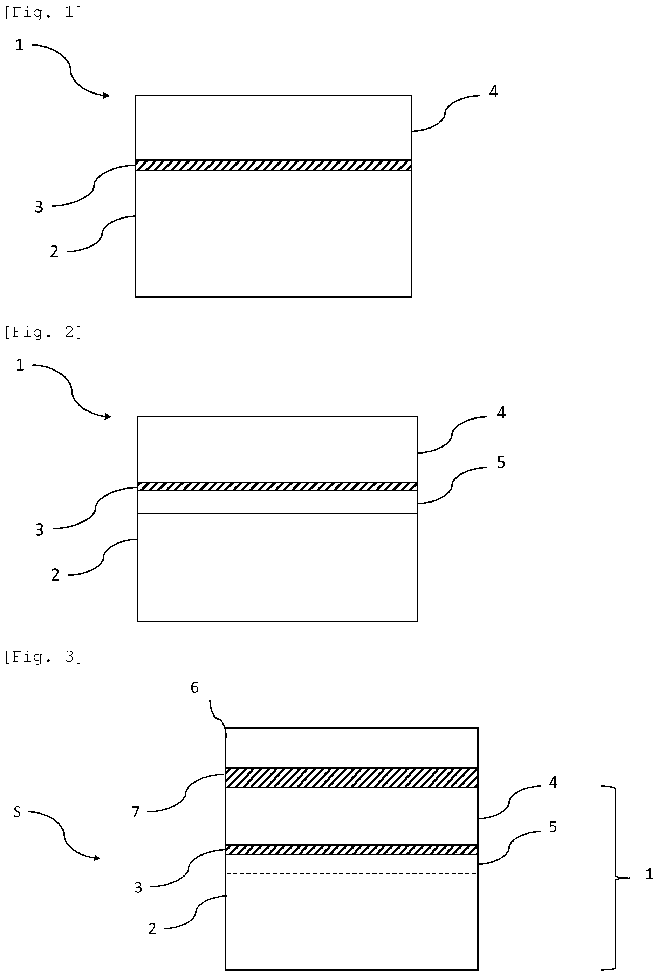

En référence à la figure 1, un substrat support 1 d'un mode de réalisation comprend un substrat de base 2, une couche diélectrique 3 disposée sur le substrat de base 2 et une couche de piégeage de charge 4 disposée sur la couche diélectrique 3 et en contact avec cette couche.

Le substrat support 1 peut prendre la forme d'une plaquette, circulaire, de dimension normalisée, par exemple de 200 mm ou 300 mm, voire 450 mm de diamètre. Mais l'invention n'est nullement limitée à ces dimensions ou à cette forme.

Le substrat de base 2 est constitué de silicium monocristallin et présente une épaisseur de plusieurs centaines de microns.

Le substrat de base 2 présente une résistivité élevée, strictement supérieure à 500 ohm.cm, préférentiellement strictement supérieure à 1000 ohms.cm, et plus préférentiellement encore supérieure à 3000 ohms.cm. On limite de la sorte la densité des charges, trous ou électrons, qui sont susceptibles de se déplacer dans le substrat de base 2, et donc détériorer la performance RF du substrat final S. Il peut s'agir par exemple d'un substrat CZ à faible teneur en oxygène interstitiel qui présente, comme cela est bien connu en soi, une résistivité qui peut être supérieure à 1000 ohms.cm.

En référence à la figure 2, le substrat support peut également comprendre une couche de silicium monocristallin intrinsèque 5, c'est-à-dire non intentionnellement dopée et donc particulièrement résistif, disposé entre le substrat de base 2 et la couche diélectrique 3. La couche de silicium monocristallin intrinsèque 5 présente avantageusement une résistivité supérieure à 2000 ohm.cm, qui peut même atteindre 20 kohm.cm ou plus. Son épaisseur peut être comprise entre 0,5 et 100 microns, et préférentiellement entre 5 et 20 microns.

La couche diélectrique 3, par exemple en oxyde de silicium ou en nitrure de silicium, présente une épaisseur supérieure à 0,5 nm, par exemple comprise entre 0,5 nm et 50 nm. Cette couche diélectrique 3, amorphe, permet de former la couche de piégeage de charges 4 sous une forme polycristalline, et d'éviter ou de limiter la recristallisation de cette couche, lorsque le substrat support 1 est exposé à une température élevée, au cours de la formation de cette couche 4 ou lors des traitements thermiques ultérieurs que le substrat support 1 est amené à subir.

Le substrat support 1 comporte également une couche de piégeage de charges 4 en silicium polycristallin, disposée sur et directement en contact avec la couche diélectrique 3. La couche de piégeage 4 présente une résistivité supérieure à 500 ohm.cm, préférentiellement supérieure à 1 kohm.cm. Comme cela a été évoqué en introduction de la présente demande, la couche de piégeage a pour fonction de piéger les porteurs de charges pouvant être présents dans le support 1 et de limiter leur mobilité. La couche de piégeage de charges 4 présente une épaisseur typiquement comprise entre 0,1 micron et 10 microns, voire même plus.

La couche de piégeage 4, du fait de sa nature non cristalline, présente des défauts structurels tels que des dislocations, des joints de grains, des zones amorphes, des interstices, des inclusions, des pores définissant des grains de la couche... Ces défauts structurels forment des pièges pour les charges susceptibles de circuler dans le matériau, par exemple au niveau de liaisons chimiques non complètes ou pendantes. On prévient ainsi la conduction dans la couche de piégeage, et le substrat support 1 présente en conséquence une performance radiofréquence élevée. Cette performance peut être établie par une mesure de caractérisation dite « de distorsion de seconde harmonique » sur un support ainsi préparé. Cette mesure est typiquement réalisée à 900MHz. On cherche d'une manière générale à ce que la mesure de distorsion soit inférieure à -70dB pour que le substrat support puisse être considéré de performance radiofréquence élevée.

Cette mesure de caractérisation, dont on trouvera une description détaillée dans le document intitulé « White paper - RF SOI wafer characterisation » de janvier 2015, publié par Soitec et dans le document US2015/0168326, est particulièrement pertinente car elle est très représentative de la performance d'un dispositif intégré RF qui serait formé sur un substrat composite incorporant le substrat support caractérisé.

La dimension des grains de la couche de piégeage 4 en silicium polycristallin est avantageusement comprise entre 50 nm (en deçà de laquelle leur stabilité thermique n'est plus assurée et où l'on risque leur recristallisation en température) et 2000 nm (au-delà de laquelle la performance RF du substrat support est affectée).

En tout état de cause, et quelle que soit précisément les caractéristiques des grains de la couche de piégeage 4, celle-ci présente une résistivité élevée supérieure à 500 ohm.cm. À cette fin, la couche de piégeage 4 n'est pas intentionnellement dopée, c'est-à-dire qu'elle présente une concentration en dopant porteur de charges inférieure à 2E13 atomes par centimètre cube. Elle peut être riche en azote ou en carbone afin d'améliorer sa caractéristique de résistivité.

Par souci d'exhaustivité, la figure 3 représente un substrat composite S qui comprend un substrat support 1 conforme à la présente invention. Comme cela ressort très clairement de cette figure, le substrat composite comprend, sur le substrat support 1, un film mince 6 réalisé de préférence en matériau cristallin. Par exemple et sans limitation, le film mince 6 peut être réalisé en matériau semi-conducteur, tel que le silicium, ou en matériau piézoélectrique, tel que le tantalate de lithium (LiTaO₃) ou du niobate de lithium (LiNbO₃).

Le substrat composite S de la figure 3 peut être formé de bien des façons à partir du substrat support 1, mais avantageusement cette formation comprend une étape de transfert du film mince 6 sur ce substrat support. Comme cela est bien connu en soi, on effectue habituellement ce transfert en assemblant des faces dites « principales » d'un substrat donneur et du substrat support 1. On prévoit généralement de munir l'une au moins de ces faces d'une couche d'assemblage diélectrique 7, typiquement d'oxyde de silicium, qui peut être formée par traitement thermique ou par dépôt. L'assemblage met préférentiellement en œuvre un collage par adhésion moléculaire.

Après cette étape d'assemblage, on réduit l'épaisseur du substrat donneur afin de former le film mince 6. Cette étape de réduction peut être effectuée par amincissement mécanique ou chimique. Elle peut aussi être exécutée par fracture au niveau d'une zone fragile préalablement introduite dans le substrat donneur, par exemple conformément aux principes de la technologie Smart Cut^{™}.

Des étapes de finition du film mince 6, telles qu'une étape de polissage, un traitement thermique sous atmosphère réductrice ou neutre ou une oxydation sacrificielle peuvent être enchaînées avec l'étape de réduction d'épaisseur.

On note que le substrat donneur peut être un simple substrat, c'est-à-dire ne comportant pas de dispositifs intégrés, ou alternativement le substrat donneur peut avoir été préalablement traité afin de réaliser des dispositifs intégrés sur sa surface.

On expose maintenant le procédé de préparation du substrat support 1 qui a fait l'objet de la section précédente de la présente description.

On introduit le substrat de base 2 en silicium monocristallin dans une chambre d'un équipement de dépôt.

Cet équipement peut correspondre à un équipement de dépôt par épitaxie. Il comprend un suscepteur disposé dans la chambre pour recevoir le substrat de base et exposer l'une de ces faces à l'atmosphère et aux flux de gaz circulant dans la chambre. Le suscepteur peut être mobile, et avoir notamment un mouvement de rotation pour uniformiser angulairement l'exposition de la face libre du substrat de base 2 au flux de gaz. Pour permettre l'introduction de ces flux et la maitrise de l'atmosphère contenue dans la chambre, celle-ci est munie d'une pluralité de ports d'entrée, et d'au moins un port d'évacuation. La chambre est également équipée d'un dispositif de chauffage du substrat, des gaz et/ou des parois de la chambre, par exemple des lampes émettant un rayonnement apte échauffer la surface libre du substrat de base. Une pluralité de conduits reliée fluidiquement aux ports d'entrée de la chambre permet d'introduire avec un débit maitrisé les gaz permettant le traitement du substrat de base 2. Il s'agit notamment d'un gaz réactif, oxydant ou nitrurant, d'un gaz porteur par exemple un mélange d'argon et d'hydrogène, ou de l'hydrogène, et d'un gaz précurseur contenant du silicium. Ce gaz précurseur peut être, à titre d'exemple, du silane, disiliane, trichlorosilane, dicholorosilane et tétrachlorure de silicium. L'équipement peut naturellement être muni d'autre conduit pour introduire d'autres gaz dans la chambre. L'équipement est également pourvu d'un dispositif de commande configuré pour piloter l'ensemble des paramètres (débits des différents gaz, température, pression...) du procédé de préparation mis en œuvre.

Le procédé de préparation du substrat support conforme à la section précédente de la présente description comprend notamment deux étapes principales, qui sont conduites sans extraire le substrat de base 2 de la chambre de l'équipement. En conséquence, le substrat de base n'est pas exposé à d'autres gaz ou atmosphère que ceux qui sont introduits ou présents dans la chambre pendant toute la durée du procédé de préparation.

Comme cela est bien connu en soi, le gaz porteur GPo est introduit dans la chambre dans un débit déterminé par l'intermédiaire d'un port d'entrée pour la balayer pendant toute la durée du procédé de préparation du substrat donneur, et notamment pendant les deux étapes principales de ce procédé.

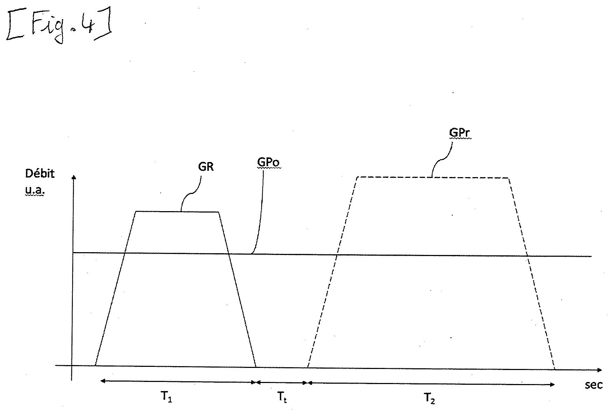

Dans une première étape, et comme cela est illustré sur la figure 4 on forme la couche diélectrique 3 sur la face exposée du substrat de base 2 en introduisant dans la chambre, et avec un débit choisi, un gaz réactif GR, au cours d'une première période de temps T1. Le dispositif de chauffage est piloté pour que la couche diélectrique soit formée à une température typiquement comprise entre 900°C et 1150°C, et préférentiellement entre 950°C et 1100°C. Selon la nature de la couche diélectrique que l'on souhaite former, dioxyde de silicium ou nitrure de silicium par exemple, ce gaz réactif peut être formé d'un gaz oxydant ou d'un gaz nitrurant. De manière préférée, la couche diélectrique est en oxyde de silicium, et dans ce cas le gaz réactif peut par exemple comprendre entre 0,1% et 10% d'oxygène dans un gaz neutre tel que de l'argon. L'atmosphère oxydante de la chambre est maintenue pendant une durée choisie (la première période de temps) selon l'épaisseur voulue de la couche diélectrique 3. Préférentiellement, la couche diélectrique 3 présente une épaisseur supérieure à 0,5 nm.

Puis, dans une deuxième étape qui suit la première, on forme une couche de piégeage de charges 4 en silicium polycristallin directement sur la couche diélectrique 3 en introduisant dans la chambre, et avec un débit choisi, le gaz précurseur GPr contenant du silicium, au cours d'une deuxième période de temps T2 postérieure à la première période de temps T1. La nature amorphe de la couche diélectrique prévient la cristallisation de la couche de piégeage qui se forme au cours de cette deuxième étape, ce qui pourrait se produire si cette couche diélectrique n'était pas présente.

L'enchainement de la première et la deuxième étape est réalisé de manière maitrisée, afin d'éviter notamment qu'un mélange des gaz réactif et précurseur ne se produise, ce qui pourrait provoquer des réactions chimiques non voulues dans la chambre et prévenir le dépôt d'une couche de piégeage de qualité visée. Dit autrement, et comme cela est très visible sur la figure 4, la première étape au cours de laquelle le gaz réactif forme l'atmosphère de la chambre ne chevauche pas la deuxième étape au cours de laquelle le gaz précurseur forme l'atmosphère de la chambre.

A l'issue de la première étape, et pendant la période de transition Tt qui sépare la fin de la première période de temps du début de la deuxième période de temps, le gaz porteur, qui balaye de manière constante la chambre pendant toute la durée du procédé de préparation, chasse le gaz réactif de la chambre. On exploite également cette période de transition pour ajuster la température de la chambre et/ou du substrat, dans le cas où la température de la première étape est différente de la température de la deuxième étape. Dans un second temps, et après cette période de transition Tt, le gaz précurseur est introduit dans la chambre. Lorsque ce gaz est introduit dans la chambre, l'atmosphère et la température de cette chambre sont donc parfaitement adaptées à la formation d'une couche de piégeage de charges 4 de qualité. Le gaz porteur et le gaz précurseur circulent simultanément dans la chambre pendant le reste de cette deuxième étape de procédé.

Conventionnellement, et comme cela a été rapporté dans l'introduction de la présente demande, la croissance de la couche de piégeage est réalisée, au moins sur une portion germe en contact avec la couche diélectrique, à une température relativement faible de 1010°C ou moins afin d'obtenir une couche de qualité satisfaisante. Cette qualité se mesure notamment par la mesure de distorsion de seconde harmonique. Elle se mesure également par la contrainte dans la couche de piégeage de charges 4 qui peut tendre à déformer le substrat si elle est trop importante. On cherche généralement à limiter cette déformation (typiquement une courbure désignée par le terme anglais "bow" dans la technologie des semi-conducteurs), pour un substrat de 300 mm de diamètre, à moins de 200 microns voire même inférieure à 100 microns.

Or, et de manière surprenante, les inventeurs de la présente demande ont observé qu'il était possible d'obtenir une couche de piégeage 4 de qualité tout à fait similaire à celle de l'état de la technique, en réalisant cette deuxième étape à une température relativement plus élevée, strictement supérieure à 1010°C, dès lors que la durée de la période de transition Tt n'excédait pas 30 secondes. Dit autrement, lorsque la durée pendant laquelle la couche diélectrique 3 est exposée uniquement au gaz porteur est inférieure à 30 secondes, la formation de la couche de piégeage de charges 4 est conduite, selon l'invention, à une température strictement comprise entre 1010°C et 1200°C, tout en présentant une qualité acceptable de cette couche, tant en déformation qu'en mesure de distorsion de seconde harmonique.

Il apparait donc qu'en limitant la durée de l'exposition de la couche diélectrique 3 au gaz porteur seul, entre la première période de temps et la deuxième période de temps, on conditionne ou on maintient l'état de surface de cette couche 3 pour la rendre particulièrement apte à la croissance directe de la couche de piégeage 4 à une température bien plus élevée que dans l'état de la technique. A cet effet, il peut être avantageux de limiter la durée pendant laquelle la couche diélectrique 3 est exposée uniquement au gaz porteur à 20 secondes ou même à 15 secondes.

On note également qu'en limitant cette durée, on évite ou on limite le phénomène de dissolution de la couche diélectrique 3 qui peut se produire pendant la période de transition. Ce phénomène de dissolution conduit à une perte d'épaisseur de cette couche diélectrique, cette perte étant proportionnelle à la durée de la période de transition Tt élevée à la puissance n, (Tt)^n, n pouvant varier entre 2 et 4 selon la température, l'épaisseur initiale de la couche diélectrique et le débit de gaz porteur. Lorsque la durée de la période de transition est excessive, l'épaisseur de la couche diélectrique est susceptible de devenir insuffisante pour permettre la formation d'une couche de piégeage de charges de qualité satisfaisante.

On rappelle qu'une température relativement élevée de formation de la couche de piégeage est une caractéristique importante dans la mesure où elle peut alors être formée bien plus rapidement, à qualité équivalente. Ainsi, la vitesse de croissance à 950°C est de l'ordre de 0,8 micron par minute, de l'ordre de 1.25 microns par minute à 1000°C et de l'ordre de 2 microns par minute à 1100°C, ce qui est notablement supérieur au 0,3 micron par minute observé à 900°C. On améliore alors significativement la cadence de production d'un substrat support par rapport à la cadence obtenue à l'aide des procédés de l'état de la technique. C'est notamment le cas lorsque la couche de piégeage est relativement épaisse, supérieure à 2 microns.

Ainsi, et pour viser une vitesse de croissance importante de la couche de piégeage 4, l'étape de formation de cette couche 4 est conduite préférentiellement à une température strictement supérieure à 1010°C, à 1050°C, ou supérieure à 1100°C.

Quelle que soit la température choisie lors de cette étape de formation de la couche de piégeage 4, celle-ci est conduite pendant une période de temps suffisante pour former une épaisseur visée de silicium polycristallin, directement sur la couche diélectrique 3.

Pour limiter la perte d'épaisseur de la couche diélectrique 2 pendant la période de transition Tt, on peut baisser la température du traitement pendant cette période, par exemple de 50°C par rapport à la température de la première période de temps.

Avantageusement, la couche de piégeage de charges 4 et la couche diélectrique 3 sont formées à des températures respectives identiques à 50°C près. Par exemple, les deux étapes peuvent s'enchainer comme cela a été présenté antérieurement en maintenant une même température de 1050°C ou de 1100°C pour la première et la deuxième étape. Puisqu'il n'est pas nécessaire d'élever ou réduire la température entre les deux étapes, la durée de la période de transition peut être réduite plus aisément, sous les 30 secondes, par exemple sous 20 secondes ou même 15 secondes.

La couche diélectrique 3 peut être formée à une température supérieure, inférieure ou égale à la température de formation de la couche de piégeage de charges 4.

De manière optionnelle, la première étape de formation de la couche diélectrique 3 peut être précédée d'un recuit de désoxydation du substrat de base dans une atmosphère réductrice ou faiblement réductrice, à une température comprise entre 900°C et 1200°C, pour éliminer un oxyde natif éventuellement présent superficiellement sur le substrat de base 2. Ce recuit peut être conduit alors que seul le gaz porteur circule dans la chambre, pendant une durée de plusieurs secondes à plusieurs minutes, selon la température choisie, afin d'éliminer cet oxyde natif.

Cette étape est particulièrement utile lorsqu'il est favorable de prévoir une couche épitaxiale en silicium intrinsèque 5 sur le substrat de base 2. Dans un tel cas, le procédé de traitement comprend, entre le recuit de désoxydation et la première étape de formation de la couche diélectrique 3, la formation de cette couche épitaxiale en silicium intrinsèque 5 sur le substrat de base 2, à une température d'épitaxie typiquement comprise entre 900°C et 1200°C. A cet effet, on peut faire circuler simultanément dans la chambre les gaz porteur et précurseur contenant du silicium.

Bien entendu, ces étapes de recuit de désoxydation et/ou de formation d'une couche épitaxiale sont également réalisées « in situ », c'est-à-dire sans extraire le substrat de base 2 de la chambre de l'équipement et sans exposer la surface libre du support 1 en cours de préparation à d'autres gaz ou atmosphère que ceux qui sont introduits ou présents dans la chambre pendant toute la durée du procédé.

## Revendications

1. Procédé de préparation d'un substrat support (1) muni d'une couche de piégeage de charges (4), le procédé comprenant l'introduction d'un substrat de base (2) en silicium monocristallin présentant une résistivité supérieure à 500 ohm.cm dans une chambre d'un équipement de dépôt et, sans extraire le substrat de base (2) de la chambre et tout en balayant la chambre à l'aide d'un gaz porteur, les étapes successives suivantes :
- former une couche diélectrique (3) sur une face exposée du substrat de base (2) en introduisant dans la chambre un gaz réactif au cours d'une première période de temps ;
- former une couche de piégeage de charges (4) en silicium polycristallin directement sur la couche diélectrique (3) en introduisant dans la chambre un gaz précurseur contenant du silicium au cours d'une deuxième période de temps postérieure à la première ;
la durée pendant laquelle la couche diélectrique (3) est exposée uniquement au gaz porteur, entre la première période de temps et la deuxième période de temps, étant inférieure à 30 secondes et l'étape de formation de la couche de piégeage de charges (4) étant conduite à une température strictement comprise entre 1010°C et 1200°C.

2. Procédé selon la revendication précédente dans lequel le gaz porteur comprend, ou est constitué, d'hydrogène.

3. Procédé selon l'une des revendications précédentes dans lequel le gaz précurseur contenant du silicium est choisi dans la liste formée du silane, disiliane, trichlorosilane, dicholorosilane et tétrachlorure de silicium.

4. Procédé selon l'une des revendications précédentes dans lequel la couche diélectrique (3) est en oxyde de silicium et le gaz réactif comprend entre 0,1% et 10% d'oxygène dans un gaz neutre tel que de l'argon.

5. Procédé selon l'une des revendications précédentes dans lequel l'étape de formation de la couche diélectrique (3) est conduite à une température comprise entre 1010°C et 1150°C.

6. Procédé selon l'une des revendications précédentes dans lequel la couche diélectrique (3) présente une épaisseur supérieure à 0,5 nm.

7. Procédé selon l'une des revendications précédentes dans lequel l'étape de formation de la couche de piégeage de charges (4) est conduite à une température supérieure à 1050°C ou à 1100°C.

8. Procédé selon l'une des revendications précédentes dans lequel la couche de piégeage de charges (4) et la couche diélectrique (3) sont formées à des températures respectives identiques à 50°C près.

9. Procédé selon l'une des revendications précédentes dans lequel la durée pendant laquelle la couche diélectrique (3) est exposée uniquement au gaz porteur est inférieure à 20 secondes ou à 15 secondes.

10. Procédé selon l'une des revendications précédentes dans lequel la couche de piégeage de charges (4) présente une épaisseur comprise entre 0,1 et 10 microns.

## Patentansprüche

1. Verfahren zum Herstellen eines Trägersubstrats (1), das mit einer Ladungseinfangschicht (4) versehen ist, das Verfahren umfassend das Einführen eines Basissubstrats (2) aus monokristallinem Silizium, das einen spezifischen Widerstand von über 500 Ohm.cm aufweist, in eine Kammer einer Abscheidungsanlage und, ohne das Basissubstrat (2) aus der Kammer zu entnehmen und während die Kammer mit einem Trägergas abgetastet wird, die folgenden aufeinanderfolgenden Schritte:
- Ausbilden einer dielektrischen Schicht (3) auf einer ausgesetzten Fläche des Basissubstrats (2) durch Einführen eines reaktiven Gases in die Kammer während einer ersten Zeitspanne;
- Ausbilden einer Ladungseinfangschicht (4) aus polykristallinem Silizium direkt auf der dielektrischen Schicht (3) durch Einführen eines siliziumhaltigen Vorläufergases in die Kammer während einer zweiten Zeitspanne nach der ersten;
wobei die Dauer, während der die dielektrische Schicht (3) nur dem Trägergas ausgesetzt ist, zwischen der ersten Zeitspanne und der zweiten Zeitspanne weniger als 30 Sekunden beträgt und der Schritt zum Ausbilden der Ladungseinfangschicht (4) bei einer Temperatur genau zwischen 1010 °C und 1200 °C durchgeführt wird.

2. Verfahren nach dem vorstehenden Anspruch, wobei das Trägergas Wasserstoff umfasst oder daraus besteht.

3. Verfahren nach einem der vorstehenden Ansprüche, wobei das siliziumhaltige Vorläufergas aus der Liste ausgewählt wird, die aus Silan, Disilian, Trichlorsilan, Dichlorsilan und Siliziumtetrachlorid ausgebildet ist.

4. Verfahren nach einem der vorstehenden Ansprüche, wobei die dielektrische Schicht (3) aus Siliziumoxid besteht und das reaktive Gas zwischen 0,1 % und 10 % Sauerstoff in einem neutralen Gas wie Argon umfasst.

5. Verfahren nach einem der vorstehenden Ansprüche, wobei der Schritt zum Ausbilden der dielektrischen Schicht (3) bei einer Temperatur zwischen 1010 °C und 1150 °C vorgenommen wird.

6. Verfahren nach einem der vorstehenden Ansprüche, wobei die dielektrische Schicht (3) eine Dicke über 0,5 nm aufweist.

7. Verfahren nach einem der vorstehenden Ansprüche, wobei der Schritt zum Ausbilden der Ladungseinfangschicht (4) bei einer Temperatur über 1050 °C oder 1100 °C durchgeführt wird.

8. Verfahren nach einem der vorstehenden Ansprüche, wobei die Ladungseinfangschicht (4) und die dielektrische Schicht (3) bei Temperaturen ausgebildet werden, die jeweils auf 50 °C genau identisch sind.

9. Verfahren nach einem der vorstehenden Ansprüche, wobei die Dauer, während der die dielektrische Schicht (3) nur dem Trägergas ausgesetzt ist, weniger als 20 Sekunden oder 15 Sekunden beträgt.

10. Verfahren nach einem der vorstehenden Ansprüche, wobei die Ladungseinfangschicht (4) eine Dicke zwischen 0,1 und 10 Mikrometern aufweist.

## Claims

1. Method for preparing a carrier substrate (1) provided with a charge-trapping layer (4), the method comprising introducing a base substrate (2) made of monocrystalline silicon having a resistivity greater than 500 ohm.cm into a chamber of a deposition device and, without extracting the base substrate (2) from the chamber and while sweeping the chamber with a carrier gas, the following successive steps:
- forming a dielectric layer (3) on an exposed face of the base substrate (2) by introducing a reactive gas into the chamber over a first period of time;
- forming a charge-trapping layer (4) made of polycrystalline silicon directly on the dielectric layer (3) by introducing a silicon-containing precursor gas into the chamber over a second period of time subsequent to the first;
the time during which the dielectric layer (3) is exposed solely to the carrier gas, between the first period of time and the second period of time, being less than 30 seconds and the step of forming the charge-trapping layer (4) being carried out at a temperature strictly between 1010°C and 1200°C.

2. Method according to the preceding claim, wherein the carrier gas comprises, or consists of, hydrogen.

3. Method according to either of the preceding claims, wherein the silicon-containing precursor gas is selected from the list formed by silane, disilane, trichlorosilane, dicholorosilane and silicon tetrachloride.

4. Method according to any of the preceding claims, wherein the dielectric layer (3) is made of silicon oxide and the reactive gas comprises between 0.1% and 10% oxygen in a neutral gas such as argon.

5. Method according to any of the preceding claims, wherein the step of forming the dielectric layer (3) is carried out at a temperature between 1010°C and 1150°C.

6. Method according to any of the preceding claims, wherein the dielectric layer (3) has a thickness greater than 0.5 nm.

7. Method according to any of the preceding claims, wherein the step of forming the charge-trapping layer (4) is carried out at a temperature greater than 1050°C or 1100°C.

8. Method according to any of the preceding claims, wherein the charge-trapping layer (4) and the dielectric layer (3) are formed at respective temperatures identical to within 50°C.

9. Method according to any of the preceding claims, wherein the time during which the dielectric layer (3) is exposed solely to the carrier gas is less than 20 seconds or 15 seconds.

10. Method according to any of the preceding claims, wherein the charge-trapping layer (4) has a thickness of between 0.1 and 10 microns.
